(19) Europäisches Patentamt
European Patent Office
Office européen des brevets

(11)  **EP 3 968 487 B1**

(12)  **EUROPEAN PATENT SPECIFICATION**

(45) Date of publication and mention
of the grant of the patent:
**03.05.2023  Bulletin 2023/18**

(21) Application number: **19927984.5**

(22) Date of filing: **07.05.2019**

(51) International Patent Classification (IPC):
**H02J 7/00** *(2006.01)*    **G01R 27/08** *(2006.01)*
**G01R 31/36** *(2020.01)*    **G01R 31/389** *(2019.01)*

(52) Cooperative Patent Classification (CPC):
**G01R 27/08; G01R 31/36; G01R 31/389;**
**H02J 7/0047; H02J 7/00714**

(86) International application number:
**PCT/CN2019/085875**

(87) International publication number:
**WO 2020/223903 (12.11.2020 Gazette 2020/46)**

(54) **CHARGING CURRENT CONTROL METHOD, ELECTRONIC DEVICE, AND POWER SUPPLY APPARATUS**

LADESTROMSTEUERUNGSVERFAHREN, ELEKTRONISCHE VORRICHTUNG UND STROMVERSORGUNGSGERÄT

PROCÉDÉ DE COMMANDE DE COURANT DE CHARGE, DISPOSITIF ÉLECTRONIQUE ET APPAREIL D'ALIMENTATION ÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.03.2022  Bulletin 2022/11**

(73) Proprietor: **GUANGDONG OPPO MOBILE TELECOMMUNICATIONS CORP., LTD.**
**Dongguan, Guangdong 523860 (CN)**

(72) Inventors:
• **LIU, Shaobin**
  **Dongguan, Guangdong 523860 (CN)**
• **BU, Changjun**
  **Dongguan, Guangdong 523860 (CN)**
• **TIAN, Chen**
  **Dongguan, Guangdong 523860 (CN)**
• **SHI, Yansong**
  **Dongguan, Guangdong 523860 (CN)**
• **LI, Jiada**
  **Dongguan, Guangdong 523860 (CN)**
• **ZHANG, Jun**
  **Dongguan, Guangdong 523860 (CN)**

(74) Representative: **Thorniley, Peter et al**
**Venner Shipley LLP**
**200 Aldersgate**
**London EC1A 4HD (GB)**

(56) References cited:
**EP-A1- 3 101 761      EP-A1- 3 229 336**
**CN-A- 104 113 114      CN-A- 104 113 114**
**CN-A- 106 549 465      CN-A- 109 474 286**
**US-A1- 2017 194 798**

**Description**

BACKGROUND OF DISCLOSURE

1. Field of the Disclosure

Embodiments of the present disclosure relate to the field of charging technology, and more specifically, to a charging current control method and an electronic device.

2. Description of the Related Art

With popularization of electronic devices (such as mobile phones, pads, bracelets, etc.), functions of electronic devices continue to be enriched. Some manufacturers have introduced electronic devices that support quick charging modes. Quick-charging technology greatly shortens charging time of electronic devices and is widely favored by users, such as EP3101761A1 disclosing a quick-charging control method provided to be applied to a charging system including a charging adapter and a mobile terminal and CN104113114A disclosing a charging method of mobile terminal self adaptation different capacity.

Currently, the quick charging technology is generally adopted in a large-current manner or a high-voltage-quick charging manner. When using quick charging technology to charge electronic devices, as the charging process progresses, after a mainboard has been used for a period of time, impedance will be increased, so that the impedance of the entire charging circuit will increase. Suppose quick charging technology is continuously used to charge electronic devices. In that case, abnormal heating will be generated in some local devices on a charging circuit, resulting in a condition of severe burnout. In view of a problem of excessive local impedance on the charging circuit causing abnormal heating or severe burnout of local devices, the overall charging path impedance can be controlled, that is, a charging current value of the charging circuit can be adjusted according to the overall charging path impedance value. However, the mainboard can actually withstand higher currents. In this case, adjusting the quick charging current or exiting the quick charging mode will cause the charging speed to decrease and the charging time is too long.

SUMMARY

Embodiments of the present disclosure provide a charging current control method, and an electronic device.

In a first aspect, a charging current control method is provided. The method is applied to an electronic device, wherein the electronic device includes a battery, a mainboard, and a charging interface, an input terminal of the mainboard is connected to an output terminal of the charging interface, an input terminal of the charging interface is connected to an output terminal of a power supply device, and an output terminal of the mainboard is connected to an input terminal of the battery, wherein the method includes: in a process of charging the battery, determining target impedance by the electronic device, wherein a value of the target impedance is calculated by a value of first impedance and a value of second impedance, the first impedance is impedance between the output terminal of the power supply device and the input terminal of the mainboard, the second impedance is an impedance between the output terminal of the mainboard and the input terminal of the battery, and the value of the target impedance is less than a value of total impedance between the output terminal of the power supply device and the input terminal of the battery; transmitting instruction information to the power supply device by the electronic device, wherein the instruction information instructs the power supply device to adjust an output current of the power supply device according to the value of the target impedance.

In a second aspect, an electronic device is provided. The electronic device includes: a mainboard, in which an input terminal of the mainboard is connected to an output terminal of a charging interface, an input terminal of the charging interface is connected to an output terminal of a power supply device, and an output terminal of the mainboard is connected to an input terminal of a battery; a controller used to execute operations including: in a process of charging the battery, determining a target impedance by the electronic device, wherein a value of the target impedance is calculated by a value of first impedance and a value of second impedance, the first impedance is an impedance between an output terminal of a power supply device and the input terminal of the mainboard, the second impedance is an impedance between the output terminal of the mainboard and the input terminal of the battery, and the value of the target impedance is less than a value of total impedance between the output terminal of the power supply device and the input terminal of the battery; transmitting instruction information to the power supply device by the electronic device, wherein the instruction information instructs the power supply device to adjust an output current of the power supply device according to the value of the target impedance.

BRIEF DESCRIPTION OF DRAWINGS

In order to describe technical solutions of embodiments of the present disclosure more clearly, drawings that need to be used in the embodiments of the present disclosure will be briefly introduced. Obviously, the drawings described below are only some embodiments of the present disclosure. For those skilled in the art, other drawings can be obtained based on these drawings, without creative work.

FIG. 1 is a schematic diagram of a charging circuit provided by an embodiment of the present disclosure;
FIG. 2 is a schematic flowchart of a charging current control method provided by an embodiment of the present disclosure;
FIG. 3 is a schematic diagram of a principle of voltage collection provided by an embodiment of the present disclosure;
FIG. 4 is a schematic flowchart of a charging current control method provided by another embodiment of the present disclosure;
FIG. 5 is a schematic structural diagram of an electronic device provided by an embodiment of the present disclosure;
FIG. 6 is a schematic flowchart of a charging current control method provided by another embodiment of the present disclosure;
FIG. 7 is a schematic flowchart of a charging current control method provided by still another embodiment of the present disclosure;
FIG. 8 is a schematic structural diagram of an electronic device provided by an embodiment of the present disclosure;
FIG. 9 is a schematic flowchart of a charging current control method provided by still another embodiment of the present disclosure;
FIG. 10 is a schematic structural diagram of a power supply device provided by an embodiment of the present disclosure;
FIG. 11 is a schematic flowchart of a charging current control method provided by still another embodiment of the present disclosure;
FIG. 12 is a schematic structural diagram of a power supply device provided by another embodiment of the present disclosure;
FIG. 13 is a schematic structural diagram of a wired charging system provided by an embodiment of the present disclosure;
FIG. 14 is a schematic structural diagram of a wired charging system provided by another embodiment of the present disclosure.

DETAILED DESCRIPTION OF EMBODIMENTS

The following will clearly and completely describe technical solutions in embodiments of the present disclosure in conjunction with drawings in the embodiments of the present disclosure. Obviously, the described embodiments are a part of the embodiments of the present disclosure, rather than all the embodiments. Based on the embodiments in the present disclosure, all other embodiments obtained by those skilled in the art without creative work shall fall within the protection scope of the present disclosure.

In order to understand the present disclosure more clearly, a working principle of quick charging will be introduced below to facilitate understanding of the subsequent solution of the present disclosure. However, it should be understood that the content introduced below is only for a better understanding of the present disclosure, and should not specifically limit the present disclosure.

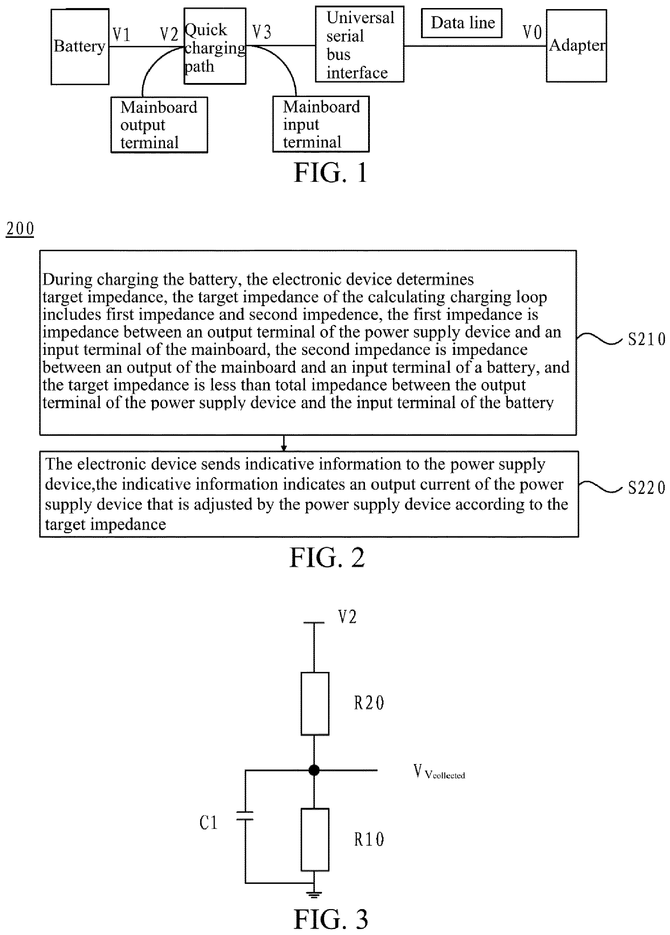

FIG. 1 is a schematic diagram of quick charging using an embodiment of the present disclosure. The schematic diagram of quick charging includes a battery, a quick charging path, a universal serial bus interface (USB interface), a data line, and an adapter. Taking a mobile phone as an example, a battery and a quick path are provided in the mobile phone, and the adapter is connected to the mobile phone via the USB interface. The USB interface can be a Micro USB interface or a Type-c USB interface. The data line in the USB interface is used for two-way communication between the adapter and the mobile phone. The data line can be a D+ line and/or D- line in the USB interface. The so-called two-way communication can refer to information exchange between the adapter and the mobile phone.

The adapter in the embodiment of the present disclosure supports a normal charging mode and a quick charging mode, wherein a charging current in the quick charging mode is greater than a charging current in the normal charging mode; alternatively, a charging voltage in the quick charging mode is higher than a charging voltage in the normal charging mode (alternatively, a charging speed in the quick charging mode is faster than a charging speed in the normal charging mode).

Generally, the normal charging mode means that the power supply device outputs a relatively small current (usually less than 2.5A) or charges the battery in the charging device with relatively small power (usually less than 15W). It usually takes several hours to fully charge a large capacity battery (such as a 3000 mAh battery) in the normal charging mode. In addition, in the quick charging mode, the power supply device can output a relatively large current (usually greater than 2.5A, such as 4.5A, 5A, or even higher) or charges the battery in the charging device with relatively large power (usually greater than or equal to 15W). Compared to the normal charging mode, the charging time required for the power supply device to fully charge the battery of the same capacity in the quick charging mode can be significantly shortened, and the charging speed is faster. In the embodiment of the present disclosure, the quick charging mode can also be divided into multiple quick charging stages according to different impedance, wherein currents in the quick charging stages show a decreasing trend as the impedance increases.

Take a mobile phone as an example, in a process of charging the mobile phone using the quick charging mode, a mobile phone transmits a battery voltage V1 near a power to a power supply device through D+ and D- signals on a data line in real time. The power supply device compares the battery voltage V1 with a voltage V0 output by the power supply device, and then divides by a charging current I, impedance R of a charging circuit can be obtained, that is, R=(V0-V1)/I. In an embodiment, a specific control method of impedance may be as shown in Table 1:

TABLE 1

| Path impedance | $R \leq R1$ | $R1 < R \leq R2$ | $R2 < R \leq R3$ | $R > R3$ |
|---|---|---|---|---|
| Quick-charging current | I1 | I2 | I3 | Exit from quick charging |

When the impedance R of the charging circuit is less than R1, the current I1 is used for performing quick charging; when the impedance increases to meet a condition of $R1 < R \leq R2$, the current of the charging circuit is controlled to drop to I2 for performing quick charging (I2< I1); if the impedance continues to increase to meet a condition of $R2 < R \leq R3$, the current of the charging circuit is controlled to drop to I3 for performing quick charging (I3< I2); if the impedance continues to increase to meet a condition of R>R3, the quick charging mode is exited, and the normal charging mode is used to charge the mobile phone.

In other words, in the process of charging the mobile phone, the power supply device continuously adjusts a charging current value in the quick charging mode according to the change of the impedance of the charging circuit until the quick charging mode is exited. However, when a mainboard is used for a period of time, its impedance value will increase, so that the impedance of the entire charging circuit will increase. According to a control method of the above-mentioned quick charging mode, the charging current will be controlled to decrease, but in fact, the mainboard can withstand a higher current.

Therefore, the embodiments of the present disclosure provide the following solutions, that can avoid blindly adjusting the quick charging current or exiting the quick charging mode due to the increase in the impedance of the mainboard.

In the following description, a charging current control method provided by an embodiment of the present disclosure will be described in detail with reference to FIG. 2.

As shown in FIG. 2, the charging current control method 200 provided by the embodiment of the present disclosure may include steps 210 to 220.

210: in a process of charging a battery, an electronic device determines target impedance, wherein the target impedance includes a first impedance and a second impedance, the first impedance is impedance between an output terminal of the power supply device and an input terminal of the mainboard, the second impedance is impedance between an output terminal of the mainboard and an input terminal of the battery, and the target impedance is smaller than total impedance between the output terminal of the power supply device and the input terminal of the battery.

In the embodiment of the present disclosure, the impedance on the mainboard is related to a charging scheme adopted by the electronic device, that is not limited to embodiments of the present disclosure. Optionally, in some embodiments, the electronic device uses a direct charging solution to charge the battery, and the mainboard may include one or more switching devices (for example, it may be a MOS transistor). In this case, the impedance of the mainboard may refer to the impedance of the one or more switching devices. Optionally, in other embodiments, the electronic device may use a common charging scheme to charge the battery, and the mainboard may include circuit devices such as a step-down circuit and a voltage stabilization circuit. In this case, the impedance of the mainboard may refer to the impedance of the circuit components such as the step-down circuit and the voltage-stabilizing circuit.

It should be understood that the target impedance in the embodiment of the present disclosure may not include impedance of the mainboard, or may include a part of the impedance of the mainboard. When the target impedance does not include the impedance of the mainboard, the target impedance may include all or a part of the impedance of the charging circuit except the mainboard. For example, it may include impedance of the USB interface and the data line, or only include impedance of the USB interface or the data line. When the target impedance includes a part of the impedance of the mainboard, the target impedance may also include all or a part of the impedance of the charging circuit except the mainboard. For example, it may include the impedance of the USB interface and the data line, or only include the impedance of the USB interface or the data line, that is not specifically limited in the present disclosure.

Optionally, in some embodiments, the first impedance may be all or a part of the impedance between the output terminal of the power supply device and the input terminal of the mainboard. In this case, the first impedance in the embodiment of the present disclosure may include the impedance of the USB interface and/or data line.

Optionally, in some embodiments, the first impedance may be all or a part of the impedance between the input terminal of the charging interface of the electronic device and the input terminal of the mainboard. In this case, the first impedance in the embodiment of the present disclosure may include the impedance of the USB interface.

It should be understood that, in some embodiments, the output voltage of the power supply device is equal to the input voltage of the charging interface of the electronic device. In this case, during the same charging process, the impedance between the output terminal of the power supply device and the input terminal of the mainboard is also equal to the impedance between the input terminal of the charging interface of the electronic device and the input terminal of the mainboard.

In the embodiment of the present disclosure, the charging circuit includes a battery, a mainboard, a USB interface, a data line, and a power supply device. The impedance of the charging circuit is a ratio of a difference between an output voltage of the power supply device and an input voltage of the battery to the charging current. The power supply device in the embodiment of the present disclosure can be understood as the above-mentioned adapter, which charges an electronic device.

220: the electronic device transmits instruction information to the power supply device, the instruction information instructs the power supply device to adjust an output current of the power supply device according to the target impedance.

Specifically, after the target impedance is obtained, the electronic device may transmit the target impedance to the power supply device, and the power supply device determines the output current of the power supply device according to the target impedance and correspondence between impedance and current.

The instruction information in the embodiments of the present disclosure may be text information or signal instructions, that are not specifically limited in the present disclosure.

In the embodiment of the present disclosure, the charging current control method is managed by the electronic device. In one embodiment, after the electronic device determines the target impedance, which is transmitted to the power supply device, and the power supply device determines the output current of the power supply device according to the target impedance and the correspondence between impedance and current. In another embodiment, the electronic device determines the target impedance and determines the output current of the power supply device according to the correspondence between impedance and current, and then the electronic device transmits the determined current to the power supply device, so that the power supply device can adjust the output current of the power supply device according to the received current.

In the charging current control method provided by the embodiments of the present disclosure, the output current of the power supply device is determined by managing the target impedance in the charging circuit. Because the determined target impedance does not include the impedance of the mainboard or includes a part of the impedance of the mainboard, the influence of the impedance of the mainboard on the adjustment of the output current of the power supply device can be avoided or reduced, so that the adjustment of the output current of the power supply device can be delayed. Compared to determining the output current of the power supply device according to the impedance of the charging circuit in the prior art, the solution provided by the present disclosure can avoid blindly adjusting the quick charging current or exiting the quick charging mode due to the increase in the impedance of the mainboard.

For ease of description, in the embodiment of the present disclosure, a process of charging with the current I1 is referred to as a first charging stage, a process of charging with the current I2 is referred to as a second charging stage, and a process of charging with the current I3 is referred to as a third charging stage.

It should be understood that, in the present embodiment, after the output current of the power supply device is determined, the output current of the power supply device may be adjusted or not adjusted. For example, if the electronic device is charged with the current I1 in the first charging stage, as the charging continues, when it is determined that the impedance is still in the first charging stage, at this time, the power supply device will not adjust the current and still charge the electronic device with the current I1 in the first charging stage; when it is determined that the impedance is still in the second charging stage, at this time, the power supply device will adjust the current to I2 to charge the electronic device.

Optionally, in some embodiments, the target impedance is $R=(V0-(V1+\Delta V))/I$, wherein V0 represents the input voltage of the power supply device, V1 represents a voltage of the input terminal of the battery, $\Delta V$ represents a voltage difference between the input terminal and the output terminal of the mainboard, and I represents the input current received by the electronic device from the power supply device.

Specifically, when the target impedance is determined, the impedance of the mainboard may not be considered, that is, the target impedance is $R=(V0-(V1+\Delta V))/I$. In this case, the determined target impedance includes impedance or partial impedance of other devices on the charging circuit in addition to the mainboard, for example, may include the impedance of the data line, the impedance of the USB interface, and so on.

In the embodiment of the present disclosure, taking a mobile phone as an example, the input voltage V3 and output voltage V2 of the mainboard can be collected to calculate the voltage difference $\Delta V$ on the mainboard $\Delta V = V3-V2$. A mobile phone transmits the voltage difference $\Delta V$ of the mainboard and the voltage V1 of a battery to the power supply device in real time. The power supply device compares the voltage difference $\Delta V$ of the mainboard and the voltage V1 of the battery with the voltage output by itself and then to be divided by the charging current I to obtain the impedance R, i.e., $R=[V0-(V1+\Delta V)]/I$. The output current of the power supply device is adjusted according to a difference of impedance R.

In the embodiment of the present disclosure, a specific method for controlling impedance may be as shown in Table 2.

TABLE 2

| Path impedance | R≤R'1 | R'1<R≤ R'2 | R'2<R≤R'3 | R> R'3 |
|---|---|---|---|---|
| Quick-charging current | I1 | I2 | I3 | Exit from quick charging |

It is understandable that, in the same charging process, taking the output voltage V0 of the power supply device and the input voltage V1 of the battery as an example, the impedance in the prior art is $R=(V0-V1)/I$. However, in the embodiment of the present disclosure, the impedance $R=[V0-(V1+\Delta V)]/I$, in the same charging process, the impedance R calculated according to the method of the embodiment of the present disclosure is less than the impedance R calculated in the prior art. For different impedance control methods, depending on the impedance control range, different charging currents may be adjusted to charge the mobile phone.

For example, in the first charging stage, the mobile phone is charged with a charging current of 4A. an initial impedance of the entire charging circuit (including the mainboard, the USB interface, and the data line) is 100mΩ, and the impedance of the mainboard is 50mΩ. As the charging process continues, when the impedance of the entire charging circuit increases to 200mΩ (R1=200mΩ), at this time, the output current of the power supply device is adjusted in the prior art and may be adjusted to 2.5A, that is, the second charging stage in entered.

However, even when the impedance of the entire charging circuit is increased to 200mΩ, there is no need to adjust the current because the mainboard can withstand a larger current. Taking the above charging process as an example, when the impedance of the entire charging circuit increases to 200mΩ (R1=200mΩ), at this time, the impedance of the mainboard may be 130mΩ, and the target impedance R calculated in the embodiment of the present disclosure is 70mΩ, corresponding to table 2, if a value of R'1 is set to 100mS2, according to the method in the embodiment of the present disclosure, the mobile phone can still be charged with the current in the first charging stage. Namely, the mobile phone can be continuously charged with the charging current of 4A, to avoid blindly adjusting the quick charging current because of the increase in the impedance of the mainboard.

In the embodiments of the present disclosure, values of R'1, R'2, and R'3 in Table 2 can be obtained according to experience or multiple debugging, but it should be noted that the values of R'1, R'2, and R'3 should be smaller than the values of R1, R2, and R3, respectively. Namely, R'1 < R1, R'2 < R2, and R'3 < R3.

The differences between R'1, R'2, and R'3 in the embodiments of the present disclosure may be equal or unequal, that is not specifically limited in the present disclosure.

In the charging current control method provided by the present disclosure, because the determined target impedance R does not include the impedance of the mainboard, the increase in the impedance of the charging circuit is not caused by the impedance of the mainboard, that can avoid to blindly adjust the quick-charge current or exit the quick-charge mode due to the increase in the impedance of the mainboard.

However, in some cases, there may be a serious problem of heat generation of the mainboard due to the continuous and rapid increase of the impedance of the mainboard. Therefore, in order to avoid this situation, a partial impedance of the mainboard should be considered when the target impedance is determined.

Optionally, in some embodiments, the target impedance is $R=(V0-(V1+I*R''))/I$, wherein V0 represents the input voltage of the power supply device, V1 represents a voltage of the input terminal of the battery, I represents the input current received by the electronic device from the power supply device, and R" is a fixed value or determined based on impedance between the input terminal and the output terminal of the mainboard.

Specifically, when determining the target impedance, in order to avoid the serious problem of heat generation of the mainboard caused by the continuous and rapid increase of the impedance of the mainboard, the partial impedance of the mainboard should be considered. Namely, the calculated target impedance is $R=(V0-(V1+I* R''))/I$, wherein R" in the embodiment of the present disclosure is a fixed value, or is determined based on the impedance between the input terminal and the output terminal of the mainboard. In this case, the determined target impedance is greater than the target impedance determined when the mainboard is completely disregarded. For the same impedance-current correspondence, the current can be switch in time in the embodiment of the present disclosure, that can avoid a serious problem with the heating of the mainboard caused by the continuous and rapid increase in the impedance of the mainboard.

In the embodiment of the present disclosure, R" may be an empirical value or a test value, that is not specifically limited in the present disclosure. R" in the embodiment of the present disclosure may be smaller than initial impedance between the input terminal and the output terminal of the mainboard, or may be smaller than the impedance measured in real time between the input terminal and the output terminal of the mainboard.

In the charging current control method provided by the present disclosure, when the target impedance is determined, compared with completely ignoring the impedance of the mainboard, because the determined target impedance includes a part of the impedance of the mainboard, it can further avoid a problem of serious heating and even burning of the mainboard due to the continuous and rapid increase of the impedance of the mainboard without considering the impedance of the mainboard.

In the process of charging the electronic device, it is necessary to collect the input voltage and the output voltage of the mainboard, i.e., the voltages V2 and V3 shown in FIG. 1. There are many ways to collect the voltages V2 and V3. Optionally, in some embodiments, the voltages V2 and V3 can be collected by using pins of an analog to digital converter (ADC) of a microcontroller unit (MCU).

The MCU is briefly introduced. The MCU is also called a single chip microcomputer (SCM) or single chip microcomputer. The MCU appropriately reduces the frequency and specifications of a central process unit (CPU) and integrates a memory, a counter (timer), a USB, an A/D converter, a UART, a PLC, a DMA, and other peripheral interfaces, and even an LCD drive circuit on a single chip to form a chip-level computer, which can be controlled in different combinations for different applications. The MCU can be seen in various applications, such as mobile phones, PC peripherals, remote controllers, automotive electronics, industrial stepping motors, and robotic arm control. In the embodiments of the present disclosure, the MCU can be applied to the mobile phone for description.

The following will specifically introduce how to use the pins of the ADC of the MCU to collect voltages.

Take the output voltage V2 of the mainboard as an example, as shown in FIG. 3, which is a schematic diagram of the ADC collection principle. In the process of charging the mobile phone, the mainboard in the mobile phone is controlled by the MCU, so the output voltage V2 of the mainboard can be collected by measuring the MCU via the pins of the ADC.

It is understandable that in the process of charging the mobile phone, if the power supply device charges the mobile phone with a voltage of 5V, and the voltage exists as an analog signal, a collected voltage is an analog signal, the signal is usually expressed in binary form. Therefore, the analog signal needs to be converted into a digital signal. Taking FIG. 3 as an example, a relationship between the voltage V2 and $V_{collected}$ is as follows:

$$V_{collected} = [R10/(R10+R20)]*V2$$

For example, if R10 and R20 in the figure are both 10000$\Omega$, and if the collected $V_{collected}$ is 1.9V, then the output voltage V2 of a quick-charge path is 3.8V.

Similarly, the input voltage V3 of the mainboard can also be collected in the same way, or can be collected in other ways, that is not specifically limited in the present disclosure.

Certainly, in the embodiment of the present disclosure, if a person wants to know more about change in the impedance of the charging circuit during the charging process, any voltage of the charging circuit can be collected, for example, the input and output voltages of the USB socket, or the input and output voltages of the data line, etc.

The above embodiments illustrate that the impedance of the mainboard can be managed separately. Namely, when the target impedance is determined, the impedance of the mainboard or a part of the impedance of the mainboard is not included, so as to avoid blindly adjusting the quick-charge flow or exiting the quick charging mode due to the increase in the impedance of the mainboard. In order to further achieve a more effective control of the impedance of the charging circuit, the target impedance can be determined according to the impedance of the mainboard. It will be introduced in detail below.

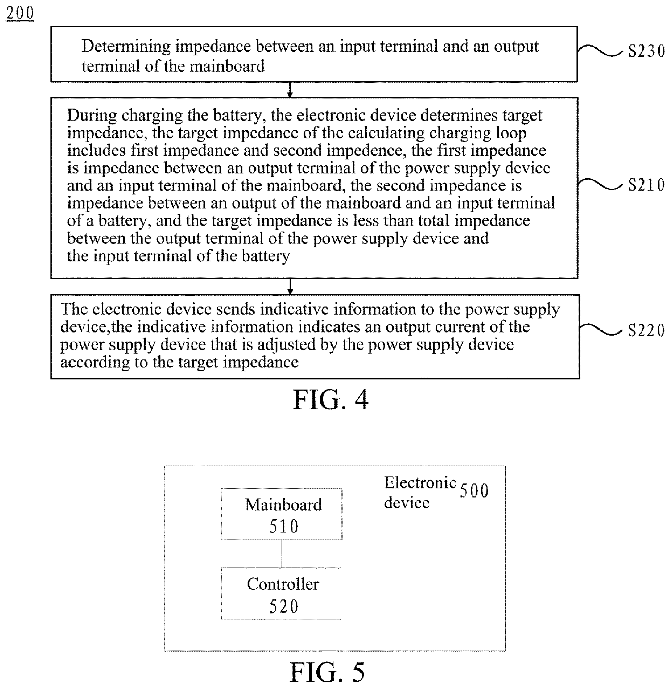

Optionally, in some embodiments, as shown in FIG. 4, before determining the target impedance, the method 200 may further include a step 230.

230: the impedance between the input terminal and the output terminal of the mainboard is calculated.

When the impedance between the input terminal and the output terminal of the mainboard is greater than a predetermined threshold R', the target impedance is determined as R=(V0-(V1+I*R"))/I. When the impedance between the input terminal and the output terminal of the mainboard is less than or equal to the predetermined threshold R', the target impedance is determined as R=(V0-V1)/I.

In the embodiment of the present disclosure, the predetermined threshold R' may be an empirical value, or may be obtained by debugging, that is not specifically limited in the present disclosure.

It can be seen from the above embodiment that the input voltage V3 and the output voltage V2 of the mainboard can be collected via the pins of the ADC, and the charging current I can be obtained from an electricity meter of the mobile phone battery, so that the impedance R of the mainboard can be obtained, i.e., the impedance R=(V3-V2)/I of the mainboard.

The target impedance is determined according to a difference in impedance between the input terminal and the output terminal of the mainboard. When the impedance between the input terminal and the output terminal of the mainboard is greater than the predetermined threshold R', the target impedance is determined to be R=(V0-(V1+I*R"))/I=(V0-V1)/I- R". When the impedance between the input terminal and the output terminal of the mainboard is less than or equal to the predetermined threshold R', the target impedance is determined as R=(V0-V1)/I.

In the embodiment of the present disclosure, R" may be equal to the predetermined threshold R', or may be less than the predetermined threshold R', that is not specifically limited in the present disclosure.

Specifically, for example, suppose that the predetermined threshold R' is 100mS2, taking a mobile phone as an example, when the mobile phone is initially charged, the mobile phone is charged with a charging current of 4A, an initial impedance of the charging circuit is 100mΩ, and the impedance between the input terminal and the output terminal of the mainboard is 50mΩ. As the charging process continues, if the impedance between the input terminal and the output terminal of the mainboard increases to 80mΩ (the impedance between the input terminal and the output terminal of the mainboard less than the predetermined threshold is 100), and the impedance of the charging circuit other than the mainboard increases to 130mΩ. At this time, the target impedance is determined to be R=(V0-V1)/I= $R_{circuit}$=80+130=210mΩ. When the impedance between the input terminal and the output terminal of the mainboard increases to 110 mΩ (the impedance between the input terminal and the output terminals of the mainboard greater than the predetermined threshold is 100), and the impedance of the charging circuit other than the mainboard increases to 160mΩ. At this time, the target impedance R=(V0-(V1+I*R"))/I=(V0-V1)/I- R"= $R_{circuit}$-R"=270- R".

In the embodiment of the present disclosure, when the impedance between the input terminal and the output terminal of the mainboard is greater than the predetermined threshold R', the target impedance is determined as R=(V0-(V1+I*R"))/I=(V0-V1)/I- R". When the impedance between the input terminal and the output terminal of the mainboard is less than or equal to the predetermined threshold R', the target impedance is determined as R=(V0-V1)/I, to which the reason will be explained.

Taking into account the impact of the impedance of the mainboard on the impedance of the charging circuit, when the impedance between the input terminal and the output terminal of the mainboard is less than the predetermined threshold R', if the determined target impedance is R=(V0-(V1+I*R"))/I=(V0-V1)/I- R", which is equivalent to reducing the value of R" on the basis of the prior art, which may cause a problem that the current cannot be adjusted in time when the impedance of the charging circuit other than the mainboard increases.

For example, suppose that the predetermined threshold R' is 100. Take the mobile phone as an example. When the mobile phone is initially charged, the mobile phone is charged with a charging current of 4A. The initial impedance of the charging circuit is 100mΩ. The impedance between the input terminal and the output terminal of the mainboard is 50mΩ. As the charging process continues, if the impedance between the input terminal and the output terminal of the mainboard increases to 80mΩ (at this time, the impedance between the input and output of the mainboard is less than the predetermined threshold), and the impedance of the charging circuit other than the mainboard is increased to 130mS2 (R1=200mΩ). If the charging current is determined according to the impedance $R_{circuit}$ of the charging circuit and the correspondence between impedance and current, i.e., the impedance $R_{circuit}$ of the charging circuit is determined as the target impedance, then the target impedance R=$R_{circuit}$ =80+130=210mΩ> R1=200mΩ. Because the impedance of the charging circuit increases and is greater than R1, the power supply device will adjust the charging current to the next charging stage. However, if the difference between the impedance of the charging circuit and R" is taken as the target impedance, that is, the charging current during the charging process is determined according to the target impedance R=$R_{circuit}$-R" and the correspondence between impedance and current. If R" is set to 20mΩ, then the target impedance R=$R_{circuit}$-R"=210- R"=190mΩ< R1=200mΩ. In this case, the power supply device will not adjust the charging current and still charge the mobile phone with a charging current of 4A (in actual situations, in the case that the impedance between the input terminal and the output terminal of the mainboard is less than the predetermined threshold R', because the impedance on the charging circuit other than the mainboard increases, the power supply device should adjust the charging current), which may cause a problem that the current cannot be adjusted in time when the impedance of the charging circuit other than the mainboard increases.

Therefore, when the impedance between the input terminal and the output terminal of the mainboard is less than the predetermined threshold R', the charging current during the charging process should be determined according to the impedance of the charging circuit, that can avoid the problem the current cannot be adjusted in time when the impedance of the charging circuit other than the mainboard increases.

In the charging current control method provided by the embodiments of the present disclosure, different target impedances are determined according to the difference of the impedances between the input terminal and the output terminal of the mainboard, so that the impedance of the mainboard can be better differentially managed, and it is possible to avoid the problem the current cannot be adjusted in time when the impedance of the charging circuit other than the mainboard increases. Meanwhile, it can avoid a problem that the continuous and rapid increase of the impedance of the mainboard without considering the impedance of the mainboard resulting in the serious heating of the mainboard or even the mainboard burned out.

Optionally, in some embodiments, when the impedance between the input terminal and the output terminal of the mainboard is greater than the predetermined threshold R', it can be adjusted according to the correspondence as shown in Table 1, or according to the correspondence as shown in Table 3.

TABLE 3

| Path impedance | $R \leq R1+R0$ | $R1+R0 < R \leq R2+R0$ | $R2+R0 < R \leq R3+R0$ | $R > R3+R0$ |
|---|---|---|---|---|
| Quick-charging current | I1 | I2 | I3 | Exit from quick charging |

Specifically, when the impedance between the input terminal and the output terminal of the mainboard is less than or equal to the predetermined threshold R', the correspondence between impedance and current can be determined according to the correspondence shown in Table 1. In the first charging stage, the mobile phone is charged with a charging current of 4A, an initial impedance of the charging circuit is 100mΩ, and the impedance between the input terminal and the output terminal of the mainboard is 50mΩ. As the charging process continues, when the impedance of the charging circuit increases to 200mΩ (R1=200mΩ), the charging current will be adjusted at this time, and may be adjusted to 2.5A, which means the second charging stage is entered.

When the impedance between the input terminal and the output terminal of the mainboard is greater than the predetermined threshold R', the correspondence between impedance and current can be determined according to the correspondence shown in Table 1. When the mobile phone is initially charged, the mobile phone is charged with a changing current of 4A, the initial impedance of the charging circuit is 100mΩ, and the impedance between the input terminal and the output terminal of the mainboard is 50mΩ. As the charging process continues, the impedance of the charging circuit increases to 500mΩ. Before the charging current is adjusted, the impedance of the charging circuit can be adjusted to obtain the target impedance, and then the charging current can be adjusted according to the target impedance. For example, the target impedance R can be adjusted as: R=$R_{circuit}$-R"=500-R". In the prior art, the adjustment is made according to the impedance of the charging circuit, that is, the charging current is adjusted according to the $R_{circuit}$=500mΩ.

Compared with the prior art, at the same time, the target impedance in the embodiment of the present disclosure is equivalent to reducing R". If R3 in Table 1 is 500mΩ, the prior art will prepare to adjust the current to exit the quick charging mode. In the embodiment of the present disclosure, because the target impedance is adjusted, the charging current may not be changed. For example, if the value of R" is set to 50mΩ, the target impedance of the charging circuit calculated by the power supply device is R=$R_{circuit}$-R"=500-R"=450mΩ<500mΩ, at this time, corresponding to Table 1, the power supply device will not adjust the current, but still charge the mobile phone with the present charging current of I3. Therefore, compared with the prior art, by managing the target impedance, the impedance control range is expanded.

In the embodiment of the present disclosure, when the impedance of the mainboard is relatively large, the correspondence between impedance and current can also be determined according to the correspondence shown in Table 3.

Specifically, when the mobile phone is initially charged, the mobile phone is charged with a charging current of 4A, an initial impedance of the charging circuit is 100mΩ, and the impedance between the input terminal and the output terminal of the mainboard is 50mΩ. As the charging process continues, the impedance of the charging circuit increases to 500mΩ. At this time, the target impedance is R=$R_{circuit}$-R"=500- R"=450mΩ, corresponding to Table 3, due to the increase of the threshold R0 on the basis of R3, at this time, the target impedance R==$R_{circuit}$-R"=500- R"=450mΩ< R3+R0, the power supply device will not adjust the charging current, or will continue to charge the phone with the present charging current of I3, the quick charging mode will not blindly exited, and the impedance control range is further expanded.

In the embodiment of the present disclosure, R0 may be an empirical value or a test value, that is not specifically limited in the present disclosure.

An embodiment of the present disclosure also provides an electronic device 500 includes a mainboard 510 and a controller 520, as shown in FIG. 5.

In the mainboard 510, an input terminal of the mainboard 510 is connected to an output terminal of a charging interface, and an output terminal of the mainboard 510 is connected to the input terminal of the battery.

In the embodiment of the present disclosure, the charging interface may be a USB dock interface, or may be a charging interface of a power supply device.

The mainboard 510 may be separately located inside the electronic device, or may be integrated with the controller and located inside the electronic device, that is not specifically limited in the present disclosure.

The controller 520 is used to execute the following operations: in a process of charging the battery, the electronic device determines target impedance, wherein the target impedance includes a first impedance and a second impedance, the first impedance is impedance between an output terminal of the power supply device and an input terminal of the mainboard, the second impedance is impedance between an output terminal of the mainboard and an input terminal of the battery, and the target impedance is smaller than total impedance between the output terminal of the power supply device and the input terminal of the battery; the electronic device transmits instruction information to the power supply device, the instruction information instructs the power supply device to adjust an output current of the power supply device according to the target impedance.

Optionally, in some embodiments, the target impedance is $R=(V0-(V1+\Delta V))/I$, wherein V0 represents the input voltage of the power supply device, V1 represents a voltage of the input terminal of the battery, $\Delta V$ represents a voltage difference between the input terminal and the output terminal of the mainboard, and I represents the input current received by the electronic device from the power supply device.

Optionally, in some embodiments, the target impedance is $R=(V0-(V1+I*R''))/I$, wherein V0 represents the input voltage of the power supply device, V1 represents a voltage of the input terminal of the battery, I represents the input current received by the electronic device from the power supply device, and R" is a fixed value or determined based on the impedance between the input terminal and the output terminal of the mainboard.

Optionally, in some embodiments, before the target impedance is determined, the controller is further used to determine the impedance between the input terminal and the output terminal of the mainboard; the controller is specifically used to when the impedance between the input terminal and the output terminal of the mainboard is greater than a predetermined threshold, the target impedance is determined to be $R=(V0-(V1+I*R''))/I$; when the impedance between the input terminal and the output terminal of the mainboard is less than or equal to the predetermined threshold, the target impedance is determined as $R=(V0-V1)/I$.

In the embodiment of the present disclosure, the electronic device 500 determines the output current of the power supply device by using the determined target impedance, and feeds back the current to the power supply device. The power supply device adjusts the output current of the power supply device during the charging process according to the current fed back by the electronic device. Alternatively, the electronic device 500 may transmit the calculated target impedance to the power supply device,. The power supply device determines the output current of the power supply device during the charging process and adjusts the output current, according to the target impedance and the correspondence between the impedance and the charging current.

Certainly, the power supply device can also transmit information to the electronic device to inquire whether the present charging current of the electronic device is suitable. After the electronic device receives the information, the electronic device can reply to the power supply device that the current current is suitable, too high, or too low. The power supply device makes further adjustments to the charging current according to the received reply information to improve the safety during the charging process.

The electronic device 500 provided by the embodiment of the present disclosure, by executing the charging current control method 200, can avoid blindly adjusting the quick charging current or exiting the quick charging mode due to the increase in the impedance of the mainboard.

As the description above, the management of the target impedance in the charging circuit can be achieved by the electronic device determining the output current of the power supply device according to the determined target impedance. The following description will explain that the electronic device determines to transmit the feedback voltage to the power supply device, so that the power supply device can determine the output current of the power supply device according to the received feedback voltage.

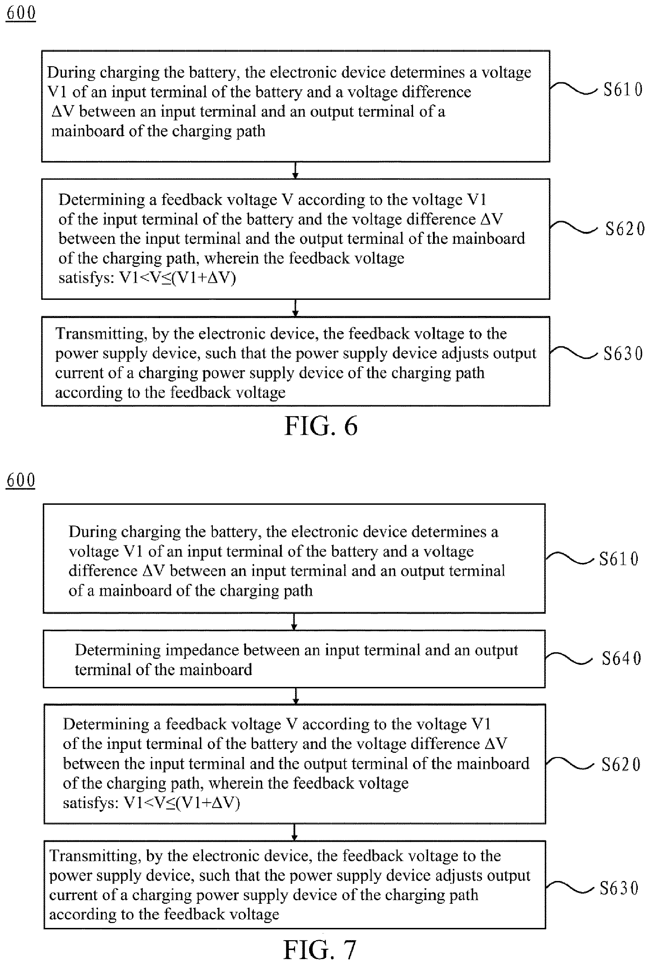

Embodiments regarding FIGs. 6 to 14 are marked as not being part of the present invention. As shown in FIG. 6, an embodiment of the present disclosure also provides a charging current control method 600, which may include steps 610 to 630.

610: in the process of charging the battery, a voltage V1 of an input terminal of a battery and a voltage difference $\Delta V$ between an input terminal and an output terminal of a mainboard is determined.

620: a feedback voltage V is determined according to the voltage V1 of the input terminal of the battery and the voltage difference $\Delta V$ between the input terminal and the output terminal of the mainboard, wherein the feedback voltage V satisfies: $V1<V\leq(V1+\Delta V)$.

630: the electronic device transmits the feedback voltage to the power supply device, so that the power supply device adjusts the output current of the power supply device according to the feedback voltage.

Specifically, in the process of using the power supply device to charge the battery, the electronic device first determines the feedback voltage according to the voltage V1 of the input terminal of the battery and the voltage difference $\Delta V$ between the input terminal and the output terminal of the mainboard, wherein the feedback voltage satisfies: $V1<V\leq(V1+\Delta V)$, and then the electronic device provides the feedback voltage to the power supply device, so that the power supply device determines the output current of the power supply device according to the feedback voltage provided by the electronic device.

In the embodiment of the present disclosure, after the power supply device receives the feedback voltage transmitted by the electronic device, the power supply device obtains the target impedance according to the feedback voltage and a charging current, and then the power supply device determines the output current of the power supply device based on correspondence between impedance and current.

It is understandable that the relationship satisfied by the feedback voltage not only can avoid blindly adjusting the quick charging flow or exiting the quick charging mode due to the increase of the impedance of the mainboard, but also can avoid the serious problem of heat generation of the mainboard caused by the continuous and rapid increase of the impedance of the mainboard.

In the charging current control method provided by the embodiments of the present disclosure, the feedback voltage for determining the target impedance is transmitted to the power supply device by the electronic device, so that the power supply device can determine the output current of the power supply device according to the received feedback voltage, because of $V1 < V \leq (V1+\Delta V)$, so the feedback voltage V does not include a voltage of the mainboard or includes a part of the voltage of the mainboard. Therefore, the target impedance determined by the power supply device can be made to not include the impedance of the mainboard or include a part of the impedance of the mainboard. In this way, the influence of the impedance of the mainboard on the adjustment of the current can be avoided or reduced, so that the adjustment of the charging current can be delayed.

Optionally, in some embodiments, the feedback voltage is $V=V1+\Delta V$.

Specifically, when the determined feedback voltage is $V=V1+\Delta V$, that is, without considering the impedance of the mainboard, the calculated impedance is $R=(V0-(V1+\Delta V))/I$. The charging current in the charging circuit is determined according to the calculated target impedance.

In the embodiment of the present disclosure, the feedback voltage determined by the electronic device may be fed back to the power supply device by a management module on the electronic device.

Optionally, in some embodiments, the feedback voltage is $V=V1+I*R''$, wherein $R''$ is a fixed value, or determined based on the impedance between the input terminal and the output terminal of the mainboard.

In the embodiment of the present disclosure, $R''$ may be an empirical value or a test value, that is not specifically limited in the present disclosure. In the embodiment of the present disclosure, $R''$ may be smaller than an initial impedance between the input terminal and the output terminal of the mainboard, or may be smaller than the impedance measured in real time between the input terminal and the output terminal of the mainboard.

Specifically, when the determined feedback voltage is $V=V1+I*R''$, due to $R''$ corresponding to the impedance of the mainboard, this method is equivalent to considering a part of the impedance of the mainboard, that can avoid the serious problem of heat generation of the mainboard caused by the continuous and rapid increase of the impedance of the mainboard.

Optionally, in some embodiments, as shown in FIG. 7, before the step 630, the charging current control method 600 may further include a step 640.

640: the impedance between the input terminal and the output terminal of the mainboard is determined.

When the impedance between the input terminal and the output terminal of the mainboard is greater than a predetermined threshold, the electronic device determines that the feedback voltage $V=V1+I*R''$.

When the impedance between the input terminal and the output terminal of the mainboard is less than the predetermined threshold, the electronic device determines that the feedback voltage $V=V1$.

In the embodiment of the present disclosure, the predetermined threshold may be an empirical value, or may be obtained through debugging, that is not specifically limited in the present disclosure.

In the embodiment of the present disclosure, the feedback voltage transmitted to the power supply device is different according to the different impedance of the mainboard, so that the power supply device determines the output current of the power supply device according to the feedback voltage. It can avoid a problem that the current cannot be adjusted in time when the impedance of the charging circuit other than the mainboard increases, and it can also avoid a problem of the serious heating of the mainboard or even the mainboard burned due to the continuous and rapid increase of the impedance of the mainboard without considering the impedance of the mainboard.

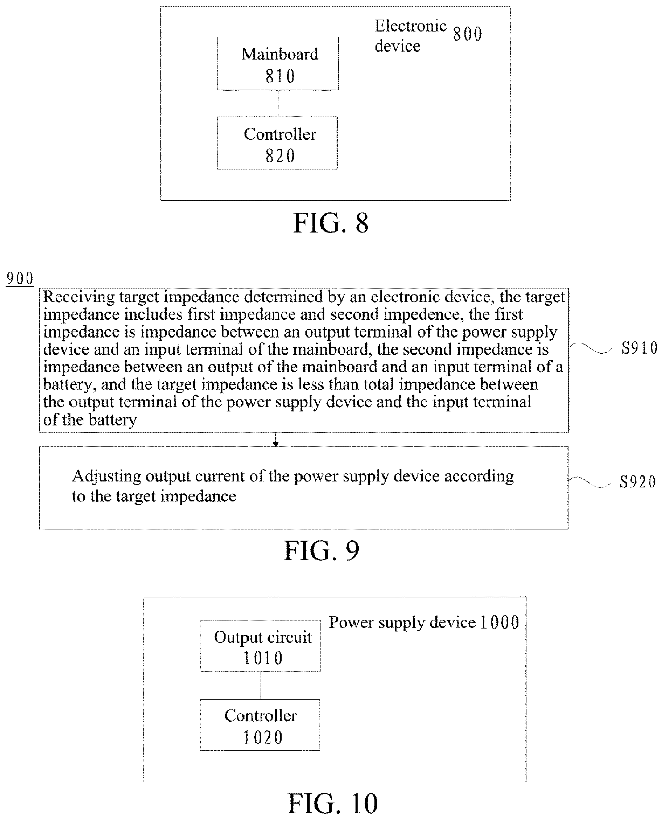

An embodiment of the present disclosure also provides an electronic device 800 includes a mainboard 810 and a controller 820, as shown in FIG. 8.

Regarding the mainboard 810, an input terminal of the mainboard is connected to an output terminal of a charging interface, and an output terminal of the mainboard is connected to an input terminal of a battery.

The controller 820 is used to perform the following operations: in a process of charging the battery, the electronic device determines a voltage V1 of the input terminal of the battery and the voltage difference $\Delta V$ between an input terminal and the output terminal of the mainboard; the feedback voltage V is determined according to the voltage V1 of the input terminal of the battery and the voltage difference $\Delta V$ between the input terminal and the output terminal of the mainboard, wherein the feedback voltage V satisfies: $V1 < V \leq (V1+\Delta V)$; the power supply device transmits the feedback voltage to the power supply device so that the power supply device can adjust the output current of the power supply device according to the feedback voltage.

In the embodiment of the present disclosure, the electronic device may be a mobile phone, a pad, or other electronic devices with quick charging performance, that is not specifically limited in the embodiment of the present disclosure.

The electronic device 800 provided by the embodiment of the present disclosure, by executing the charging current control method 600, can avoid blindly adjusting the quick charging current or exiting the quick charging mode due to the increase in the impedance of the mainboard.

Optionally, in some embodiments, the feedback voltage is $V=V1+\Delta V$

Optionally, in some embodiments, the feedback voltage is $V=V1+I*R''$, wherein I represents an input current received by the electronic device from the power supply device, and R" is fixed value or determined based on the impedance between the input terminal and the output terminal of the mainboard.

Optionally, in some embodiments, before the feedback voltage is determined, the controller is further used to determine the impedance between the input terminal and the output terminal of the mainboard. The controller is specifically used to: determine the feedback voltage $V=V1+I*R''$ when the impedance between the input terminal and the output terminal of the mainboard is greater than a predetermined threshold; and determine the feedback voltage $V=V1$ when the impedance between the input terminal and the output terminal of the mainboard is less than the predetermined threshold.

The solution of the present disclosure is described by using the above embodiments from the electronic device. In addition, the solution of the present disclosure is described from the power supply device with reference to FIGs. 9 to 12.

As shown in FIG. 9, an embodiment of the present disclosure provides a charging current control method 900, and the method 900 may include steps 910 to 920.

910: target impedance determined by an electronic device is received, the target impedance includes a first impedance and a second impedance, the first impedance is impedance between an output terminal of the power supply device and an input terminal of the mainboard, the second impedance is impedance between an output terminal of the mainboard and an input terminal of the battery, and the target impedance is smaller than total impedance between the output terminal of the power supply device and the input terminal of the battery.

920: an output current of the power supply device is adjusted according to the target impedance.

Optionally, in some embodiments, the target impedance is $R=(V0-(V1+\Delta V))/I$, wherein V0 represents the input voltage of the power supply device, V1 represents a voltage of the input terminal of the battery, $\Delta V$ represents the voltage difference between the input terminal and the output terminal of the mainboard, and I represents the output current provided by the power supply device.

Optionally, in some embodiments, the target impedance $R=(V0-(V1+I*R''))/I$, wherein V0 represents the input voltage of the power supply device, V1 represents the voltage of the input terminal of the battery, I represents the output current provided by the power supply device, and R" is a fixed value or determined based on the impedance between the input terminal and the output terminal of the mainboard.

In an embodiment of the present disclosure, a power supply device 1000 is also provided, as shown in FIG. 10. The power supply device 1000 includes an output circuit 1010 and a controller 1020.

The output circuit 1010 is used to provide an output current to an electronic device. The controller 1020 is used to receive target impedance determined by the electronic device, wherein the target impedance includes a first impedance and a second impedance, the first impedance is impedance between an output terminal of the power supply device and an input terminal of the mainboard, the second impedance is impedance between an output terminal of the mainboard and an input terminal of the battery, and the target impedance is smaller than total impedance between the output terminal of the power supply device and the input terminal of the battery; and adjust an output current of the power supply device according to the target impedance.

Optionally, in some embodiments, the target impedance is $R=(V0-(V1+\Delta V))/I$, wherein V0 represents the input voltage of the power supply device, V1 represents a voltage of the input terminal of the battery, $\Delta V$ represents the voltage difference between the input terminal and the output terminal of the mainboard, and I represents the output current provided by the power supply device.

Optionally, in some embodiments, the target impedance $R=(V0-(V1+I*R''))/I$, wherein V0 represents the input voltage of the power supply device, V1 represents the voltage of the input terminal of the battery, I represents the output current provided by the power supply device, and R" is a fixed value or determined based on the impedance between the input terminal and the output terminal of the mainboard.

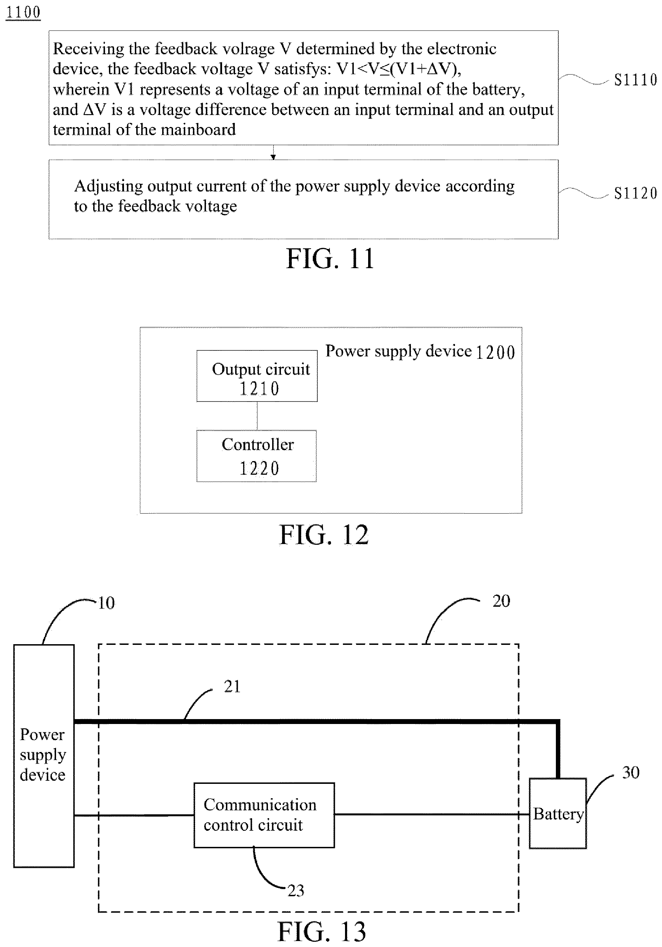

In an embodiment of the present disclosure, a charging current control method 1100 is provided, as shown in FIG. 11. The method 1100 may include steps 1110 to 1120.

1110: a feedback voltage V determined by an electronic device is received, wherein the feedback voltage V satisfies: $V1<V\leq(V1+\Delta V)$, wherein V1 represents an voltage at an input terminal of the battery, and $\Delta V$ represents a voltage difference between an input terminal and an output terminal of an mainboard.

1120: an output current of the power supply device is adjusted according to the feedback voltage.

Optionally, in some embodiments, the feedback voltage $V=V1+\Delta V$

Optionally, in some embodiments, the feedback voltage V=V1+I*R", wherein I represents the output current provided by the power supply device, and R" is a fixed value or determined based on the impedance between the input terminal and the output terminal of the mainboard.

In an embodiment of the present disclosure, a power supply device 1200 is also provided, as shown in FIG. 12. The device 1200 includes an output circuit 1210 and a controller 1220.

The output circuit 1210 is used to provide an output current to an electronic device.

The controller 1220 is used to receive the feedback voltage V determined by the electronic device, wherein the feedback voltage V satisfies: V1<V≤(V1+ΔV), wherein V1 represents a voltage of the input terminal of the battery , ΔV represents a voltage difference between the input terminal and the output terminal of the mainboard; and adjust the output current of the power supply device according to the feedback voltage.

Optionally, in some embodiments, the feedback voltage V=V1+ΔV

Optionally, in some embodiments, the feedback voltage is V=V1+I*R", wherein I represents the output current provided by the power supply device, and R" is a fixed value or determined based on the The impedance between the input terminal and the output terminal of the mainboard.

In an embodiment of the present disclosure, a computer-readable storage medium is also provided and stores computer-executable instructions. The computer-executable instructions are used to execute any one of the charging current control methods 200, 600, 900, or 1100 described above.

In an embodiment of the present disclosure, a computer program product is also provided. The computer program product includes a computer program stored on a computer-readable storage medium. The computer program includes program instructions, when the program instructions are executed by a computer, the computer program make the computer execute any one of the charging current control methods 200, 600, 900, or 1100 described above.

The solutions of the embodiments of the present disclosure can be applied in a wired charging process.

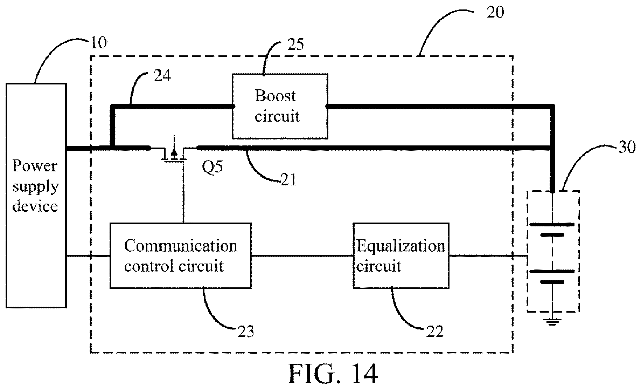

The wired charging process applied in the embodiment of the present disclosure will be described below with reference to FIGs. 13 and 14.

FIG. 13 is a schematic structural diagram of a charging system provided by an embodiment of the present disclosure. The charging system includes a power supply device 10, a battery management circuit 20 and a battery 30. The battery management circuit 20 can be used to manage the battery 30.

As an example, the battery management circuit 20 can manage a charging process of the battery 30, such as selecting a charging path and controlling a charging voltage and/or charging current. As another example, the battery management circuit 20 can manage a plurality of battery cells of the battery 30, such as equalizing voltages of the battery cells in the battery 30.

The battery management circuit 20 may include a first charging path 21 and a communication control circuit 23.

The first charging path 21 can be used to receive the charging voltage and/or charging current provided by the power supply device 10 and load the charging voltage and/or charging current on both terminals of the battery 30 to charge the battery 30. The first charging path 21 can be understood as a charging path or path described above, and can be used to charge the battery 30.

The first charging path 21 may be, for example, a wire, and some other circuit devices that are not related to the conversion of the charging voltage and/or the charging current may also be provided on the first charging path 21. For example, the power management circuit 20 includes a first charging path 21 and a second charging path, and a switching device for switching between the charging paths may be provided on the first charging path 21 (specifically referring to the description of FIG. 14).

In the embodiment of the present disclosure, the type of the power supply device 10 is not specifically limited. For example, the power supply device 10 may be a device specially used for charging such as an adapter and a power bank, or may be a computer and other devices capable of providing power and data services.

The first charging path 21 may be a direct charging path, which can directly load the charging voltage and/or charging current provided by the power supply device 10 on both terminals of the battery 30. In order to realize the direct charging method, the embodiment of the present disclosure introduces a control circuit with a communication function, that is, the communication control circuit 23, into the battery management circuit 20. The communication control circuit 23 can maintain communication with the power supply device 10 during a direct charging process to form a closed-loop feedback mechanism, so that the power supply device 10 can obtain the status of the battery in real time, thereby continuously adjusting the charging voltage and/or the charging current injected into the first charging path to ensure that the charging voltage and/or the charging current provided by the power supply device 10 match the present charging stage of the battery 30.

For example, the communication control circuit 23 can communicate with the power supply device 10 when the voltage of the battery 30 reaches a charging cut-off voltage corresponding to a constant current stage, so that the power supply device 10 converts the charging process of the battery 30 from a constant current charging process to a constant voltage charging process. For another example, the communication control circuit 23 can communicate with the power supply device 10 when the charging current of the battery 30 reaches a charging cut-off current corresponding

13

to a constant voltage stage, so that the power supply device 10 converts the charging process of the battery 30 from the constant voltage charging process to the constant current charging process.

The battery management circuit provided in the embodiment of the present disclosure can directly charge the battery. In other words, the battery management circuit provided in the embodiment of the present disclosure is a battery management circuit that supports a direct charging architecture. In the direct charging architecture, there is no need to provide a conversion circuit on the direct charging path, thereby being able to reduce the heat generated by the device to be charged during the charging process. Optionally, in some embodiments, as shown in FIG. 14, the battery management circuit 20 may further include a second charging path 24. A boost circuit 25 is provided on the second charging path 24. During the process of the power supply device 10 charging the battery 30 via the second charging path 24, the boost circuit 25 can be used to receive an initial voltage provided by the power supply device 10, boost the initial voltage to a target voltage, and charge the battery 30 based on the target voltage, wherein the initial voltage is less than a total voltage of the battery 30, and the target voltage is greater than the total voltage of the battery 30. The communication control circuit 23 can also be used to control the switching between the first charging path 21 and the second charging path 24.

Suppose that the battery 30 includes multiple battery cells, the second charging path 24 can be compatible with a common power supply device to charge the battery 30 to solve a problem that the common power supply device cannot charge multiple batteries.

For a battery 30 containing multiple battery cells, the battery management circuit 20 may also include an equalization circuit 22, referring to the above description, the equalization circuit 22 can be used to balance the voltages of the multiple battery cells during the charging process and/or discharging process of the battery.

The specific form of the boost circuit 25 is not limited in the embodiment of the present disclosure. For example, a boost circuit can be used, or a charge pump can be used, for boosting. Optionally, in some embodiments, the second charging path 24 may adopt a traditional charging path design method, that is, a conversion circuit (such as a charging IC) is provided on the second charging path 24. The conversion circuit can perform constant voltage and constant current control on the charging process of the battery 30, and adjust the initial voltage provided by the power supply device 10 according to actual requirements, such as step-up or step-down. The embodiment of the present disclosure can use a boost function of the conversion circuit to boost the initial voltage provided by the power supply device 10 to the target voltage.

The communication control circuit 23 can implement the switching between the first charging path 21 and the second charging path 24 by a switching device. Specifically, as shown in FIG. 14, the first charging path 21 may be provided with a switch Q5. When the communication control circuit 23 controls the switch Q5 to be turned on, the first charging path 21 operates to directly charge the battery 30. When the communication control circuit 23 controls the switch Q5 to be turned off, the second charging path 24 operates to charge the battery 30 by adopting the second charging path 24. In the embodiment of the present disclosure, the switch Q5 may be a MOS transistor or a switch.

In other embodiments, a circuit or device for step-down can also be provided on the second charging path 24, and when the voltage provided by the power supply device is higher than a required voltage of the battery 30, the step-down process can be performed. In the embodiment of the present disclosure, the circuit or module included in the second charging path 24 is not limited.

In the above-mentioned embodiments, it may be implemented in whole or in part by software, hardware, firmware or any other combination. When it is implemented by software, the implementation can be implemented in the form of a computer program product in whole or in part. The computer program product includes one or more computer instructions. When the computer program instructions are loaded and executed on a computer, processes or functions described in the embodiments of the present disclosure can be generated in whole or in part. The computer may be a general-purpose computer, a special-purpose computer, a computer network, or other programmable devices. The computer instructions may be stored in a computer-readable storage medium, or transmitted from one computer-readable storage medium to another computer-readable storage medium. For example, the computer instructions may be transmitted from a website, computer, server, or data center to another website, computer, server or data center in a wired manner (such as coaxial cable, optical fiber, and digital subscriber line (DSL)) or a wireless manner (such as infrared, wireless, and microwave). The computer-readable storage medium may be any available medium that can be accessed by a computer or a data storage device such as a server or data center integrated with one or more available media. The usable medium may be a magnetic medium (for example, a floppy disk, a hard disk, a magnetic tape), an optical medium (for example, a digital video disc (DVD)), or a semiconductor medium (for example, a solid state disk (SSD)), etc.

Those skilled in the art may be aware that the units and algorithm steps of the examples described in combination with the embodiments disclosed herein can be implemented by electronic hardware or a combination of computer software and electronic hardware. Whether these functions are executed by hardware or software depends on the specific application and design constraint conditions of the technical solution. Professional technicians can use different methods for each specific application to implement the described functions, but such implementation should not be considered beyond the scope of the present disclosure.

In the several embodiments provided in the present disclosure, it should be understood that the disclosed systems, devices, and methods may be implemented in other ways. For example, the device embodiments described above are merely illustrative. For example, a division of the units is only a logical function division, and there may be other divisions in actual implementation. For example, multiple units or components may be combined or it can be integrated into another system, or some features can be ignored or not implemented. In addition, the displayed or discussed mutual coupling or direct coupling or communication connection may be indirect coupling or communication connection via some interfaces, devices or units, and may be in electrical, mechanical or other forms.

As the description used in the present disclosure, although the terms "first", "second", etc. may be used in the present disclosure to describe various devices, these devices should not be limited by these terms. These terms are only used to distinguish one device from another. For example, in the case of the meaning of the description without change, the first device can be called as the second device, and similarly, the second device can be called as the first device, as long as all occurrences of "first device" are renamed consistently and all occurrences of the "second device" are renamed consistently. The first device and the second device are both devices, but they may not be the same device.

The units described as separate components may or may not be physically separated, and the components displayed as units may or may not be physical units, that is, they may be located in one place, or they may be distributed on multiple network units. Some or all of units may be selected according to actual requirements to achieve the objectives of the solutions of the embodiments.

In addition, functional units in the various embodiments of the present disclosure may be integrated into one processing unit, or each unit may exist alone physically, or two or more units may be integrated into one unit.

The above descriptions are only specific implementations of the present disclosure, to which the protection scope of the present disclosure is not limited. Within the scope of the technology disclosed in the present disclosure, any person skilled in the art can easily think of changes or substitutions, which should be covered by the scope of protection of the present disclosure. Therefore, the protection scope of the present disclosure should be subject to the protection scope of the claims. The invention is defined by the features of the independent claims 1 and 5. Preferred embodiments are defined in the dependent claims.

## Claims

1. A charging current control method (200), applied to an electronic device, wherein the electronic device (500) comprises a battery, a mainboard (510), and a charging interface, an input terminal of the mainboard is connected to an output terminal of the charging interface, an input terminal of the charging interface is connected to an output terminal of a power supply device, and an output terminal of the mainboard is connected to an input terminal of the battery,

   **characterized in that** the method comprises:

   in a process of charging the battery, determining (S210) a target impedance by the electronic device, wherein a value of the target impedance is calculated by a value of a first impedance and a value of a second impedance, the first impedance is the impedance between the output terminal of the power supply device and the input terminal of the mainboard, the second impedance is the impedance between the output terminal of the mainboard and the input terminal of the battery, and the value of the target impedance is less than a value of total impedance between the output terminal of the power supply device and the input terminal of the battery; transmitting (S220) instruction information to the power supply device by the electronic device, wherein the instruction information instructs the power supply device to adjust an output current of the power supply device according to the value of the target impedance.

2. The method as claimed in claim 1, **characterized in that** the value of the target impedance is $R=(V0-(V1+\Delta V))/I$, wherein V0 represents an input voltage of the power supply device, V1 represents a voltage of the input terminal of the battery, $\Delta V$ represents a voltage difference between the input terminal and the output terminal of the mainboard, and I represents an input current received by the electronic device from the power supply device.

3. The method as claimed in claim 1, **characterized in that** the value of the target impedance is $R=(V0-(V1+I*R''))/I$, wherein V0 represents an input voltage of the power supply device, V1 represents a voltage of the input terminal of the battery, I represents an input current received by the electronic device from the power supply device, and R" is a fixed value or determined based on impedance between the input terminal and the output terminal of the mainboard.

4. The method as claimed in claim 3, **characterized in that** before the determining the target impedance by the electronic device, the method further comprises:

determining (S230) impedance between the input terminal and the output terminal of the mainboard;
wherein the determining the target impedance comprises:

determining the target impedance as $R=(V0-(V1+I*R''))/I$ in response to the impedance between the input terminal and the output terminal of the mainboard being greater than a predetermined threshold;
determining the target impedance as $R=(V0-V1)/I$ in response to the impedance between the input terminal and the output terminal of the mainboard being less than or equal to the predetermined threshold.

5. An electronic device (500), comprising:

a mainboard (510), in which an input terminal of the mainboard is connected to an output terminal of a charging interface, an input terminal of the charging interface is connected to an output terminal of a power supply device, and an output terminal of the mainboard is connected to an input terminal of a battery;
a controller (520); **characterized in that** the controller is configured to execute operations comprising:

in a process of charging the battery, determining a target impedance by the electronic device, wherein a value of the target impedance is calculated by a value of a first impedance and a value of a second impedance, the first impedance is the impedance between the output terminal of the power supply device and the input terminal of the mainboard, the second impedance is the impedance between the output terminal of the mainboard and the input terminal of the battery, and the value of the target impedance is less than a value of total impedance between the output terminal of the power supply device and the input terminal of the battery;
transmitting instruction information to the power supply device by the electronic device, wherein the instruction information instructs the power supply device to adjust an output current of the power supply device according to the value of the target impedance.

6. The electronic device as claimed in claim 5, **characterized in that** the target impedance is $R=(V0-(V1+\Delta V))/I$, wherein V0 represents an input voltage of the power supply device, V1 represents a voltage of the input terminal of the battery, $\Delta V$ represents a voltage difference between the input terminal and the output terminal of the mainboard, and I represents an input current received by the electronic device from the power supply device.

7. The electronic device as claimed in claim 5, **characterized in that** the target impedance is $R=(V0-(V1+I*R''))/I$, wherein V0 represents an input voltage of the power supply device, V1 represents a voltage of the input terminal of the battery, I represents an input current received by the electronic device from the power supply device, and R'' is a fixed value or determined based on impedance between the input terminal and the output terminal of the mainboard.

8. The electronic device as claimed in claim 7, **characterized in that** before the determining the target impedance, the controller is further configured to:

determine the impedance between the input terminal and the output terminal of the mainboard;
wherein the controller is specifically configured to:

determine the target impedance as $R=(V0-(V1+I*R''))/I$ in response to the impedance between the input terminal and the output terminal of the mainboard being greater than a predetermined threshold;
determine the target impedance as $R=(V0-V1)/I$ in response to the impedance between the input terminal and the output terminal of the mainboard being less than or equal to the predetermined threshold.

**Patentansprüche**

1. Ladestromsteuerverfahren (200), das in einer elektronischen Vorrichtung angewandt wird, wobei die elektronische Vorrichtung (500) eine Batterie, eine Hauptplatine (510) und eine Ladeschnittstelle umfasst, wobei eine Eingangsklemme der Hauptplatine mit einer Ausgangsklemme der Ladeschnittstelle verbunden ist, wobei eine Eingangsklemme der Ladeschnittstelle mit einer Ausgangsklemme einer Stromversorgungsvorrichtung verbunden ist und wobei eine Ausgangsklemme der Hauptplatine mit einer Eingangsklemme der Batterie verbunden ist,

**dadurch gekennzeichnet, dass** das Verfahren umfasst:

in einem Prozess eines Ladens der Batterie, Ermitteln (S210) einer Zielimpedanz durch die elektronische Vorrichtung,

wobei ein Wert der Zielimpedanz durch den Wert einer ersten Impedanz und einen Wert einer zweiten Impedanz berechnet wird, wobei die erste Impedanz die Impedanz zwischen der Ausgangsklemme der Stromversorgungsvorrichtung und der Eingangsklemme der Hauptplatine ist, wobei die zweite Impedanz die Impedanz zwischen der Ausgangsklemme der Hauptplatine und der Eingangsklemme der Batterie ist, und wobei der Wert der Zielimpedanz geringer als ein Wert der Gesamtimpedanz zwischen der Ausgangsklemme der Stromversorgungsvorrichtung und der Eingangsklemme der Batterie ist;

Übertragen (S220) von Befehlsinformationen von der elektronischen Vorrichtung zu der Stromversorgungsvorrichtung, wobei die Befehlsinformationen die Stromversorgungsvorrichtung anweisen, einen Ausgangsstrom der Stromversorgungsvorrichtung gemäß dem Wert der Zielimpedanz anzupassen.

2. Verfahren nach Anspruch 1, **dadurch gekennzeichnet, dass** der Wert der Zielimpedanz $R = (V0 - (V1 + \Delta V))/I$ ist, wobei V0 eine Eingangsspannung der Stromversorgungsvorrichtung repräsentiert, V1 eine Spannung der Eingangsklemme der Batterie repräsentiert, $\Delta V$ eine Spannungsdifferenz zwischen der Eingangsklemme und der Ausgangsklemme der Hauptplatine repräsentiert und I einen Eingangsstrom repräsentiert, der in der elektronischen Vorrichtung von der Stromversorgungsvorrichtung empfangen wird.

3. Verfahren nach Anspruch 1, **dadurch gekennzeichnet, dass** der Wert der Zielimpedanz $R = (V0 - (V1 + I * R''))/I$ ist, wobei V0 eine Eingangsspannung der Stromversorgungsvorrichtung repräsentiert, V1 eine Spannung der Eingangsklemme der Batterie repräsentiert, I einen Eingangsstrom repräsentiert, der in der elektronischen Vorrichtung von der Stromversorgungsvorrichtung empfangen wird, und $R''$ ein fester Wert ist oder aufgrund einer Impedanz zwischen der Eingangsklemme und der Ausgangsklemme der Hauptplatine ermittelt wird.

4. Verfahren nach Anspruch 3, **dadurch gekennzeichnet, dass** das Verfahren vor dem Ermitteln der Zielimpedanz durch die elektronische Vorrichtung außerdem umfasst:

Ermitteln (S230) einer Impedanz zwischen der Eingangsklemme und der Ausgangsklemme der Hauptplatine;
wobei das Ermitteln der Zielimpedanz umfasst:

Ermitteln der Zielimpedanz als $R = (V0 - (V1 + I * R''))/I$ als Reaktion darauf, dass die Impedanz zwischen der Eingangsklemme und der Ausgangsklemme der Hauptplatine größer als ein vorbestimmter Schwellenwert ist;
Ermitteln der Zielimpedanz als $R = (V0 - V1)/I$ als Reaktion darauf, dass die Impedanz zwischen der Eingangsklemme und der Ausgangsklemme der Hauptplatine geringer als der, oder gleich dem vorbestimmten Schwellenwert ist.

5. Elektronische Vorrichtung (500), umfassend:

eine Hauptplatine (510), wobei eine Eingangsklemme der Hauptplatine mit einer Ausgangsklemme einer Ladeschnittstelle verbunden ist, wobei eine Eingangsklemme der Ladeschnittstelle mit einer Ausgangsklemme einer Stromversorgungsvorrichtung verbunden ist und wobei eine Ausgangsklemme der Hauptplatine mit einer Eingangsklemme einer Batterie verbunden ist;
eine Steuereinheit (520); **dadurch gekennzeichnet, dass** die Steuereinheit konfiguriert ist zum Ausführen von Operationen, die umfassen:

in einem Prozess eines Ladens der Batterie, Ermitteln einer Zielimpedanz durch die elektronische Vorrichtung, wobei ein Wert der Zielimpedanz durch den Wert einer ersten Impedanz und einen Wert einer zweiten Impedanz berechnet wird, wobei die erste Impedanz die Impedanz zwischen der Ausgangsklemme der Stromversorgungsvorrichtung und der Eingangsklemme der Hauptplatine ist, wobei die zweite Impedanz die Impedanz zwischen der Ausgangsklemme der Hauptplatine und der Eingangsklemme der Batterie ist, und wobei der Wert der Zielimpedanz geringer als ein Wert der Gesamtimpedanz zwischen der Ausgangsklemme der Stromversorgungsvorrichtung und der Eingangsklemme der Batterie ist;
Übertragen von Befehlsinformationen von der elektronischen Vorrichtung zu der Stromversorgungsvorrichtung, wobei die Befehlsinformationen die Stromversorgungsvorrichtung anweisen, einen Ausgangsstrom der Stromversorgungsvorrichtung gemäß dem Wert der Zielimpedanz anzupassen.

6. Elektronische Vorrichtung nach Anspruch 5, **dadurch gekennzeichnet, dass** die Zielimpedanz R = (V0 - (V1 + ∆V))/I ist, wobei V0 eine Eingangsspannung der Stromversorgungsvorrichtung repräsentiert, V1 eine Spannung der Eingangsklemme der Batterie repräsentiert, ∆V eine Spannungsdifferenz zwischen der Eingangsklemme und der Ausgangsklemme der Hauptplatine repräsentiert und I einen Eingangsstrom repräsentiert, der in der elektronischen Vorrichtung von der Stromversorgungsvorrichtung empfangen wird.

7. Elektronische Vorrichtung nach Anspruch 5, **dadurch gekennzeichnet, dass** die Zielimpedanz R = (V0 - (V1 + I * R"))/I ist, wobei V0 eine Eingangsspannung der Stromversorgungsvorrichtung repräsentiert, V1 eine Spannung der Eingangsklemme der Batterie repräsentiert, I einen Eingangsstrom repräsentiert, der in der elektronischen Vorrichtung von der Stromversorgungsvorrichtung empfangen wird, und R" ein fester Wert ist oder aufgrund einer Impedanz zwischen der Eingangsklemme und der Ausgangsklemme der Hauptplatine ermittelt wird.

8. Elektronische Vorrichtung nach Anspruch 7, **dadurch gekennzeichnet, dass** die Steuereinheit vor dem Ermitteln der Zielimpedanz außerdem konfiguriert ist zum:

   Ermitteln der Impedanz zwischen der Eingangsklemme und der Ausgangsklemme der Hauptplatine;
   wobei die Steuereinheit insbesondere konfiguriert ist zum:

   Ermitteln der Zielimpedanz als R = (V0 - (V1 + I * R"))/I als Reaktion darauf, dass die Impedanz zwischen der Eingangsklemme und der Ausgangsklemme der Hauptplatine größer als ein vorbestimmter Schwellenwert ist;
   Ermitteln der Zielimpedanz als R = (V0 - V1)/I als Reaktion darauf, dass die Impedanz zwischen der Eingangsklemme und der Ausgangsklemme der Hauptplatine geringer als der, oder gleich dem vorbestimmten Schwellenwert ist.

## Revendications

1. Procédé de commande de courant de charge (200), appliqué à un dispositif électronique, ce dispositif électronique (500) comportant une pile, une carte mère (510), et une interface de charge, une borne d'entrée de la carte mère étant connectée à une borne de sortie de l'interface de charge, une borne d'entrée de l'interface de charge étant connectée à une borne de sortie d'un dispositif d'alimentation électrique, et une borne de sortie de la carte mère étant connectée à une borne d'entrée de la pile,
   **caractérisé en ce que** ce procédé comprend :

   dans un processus de charge de la pile, la détermination (S210) d'une impédance cible par le dispositif électronique, une valeur de cette impédance cible étant calculée par une valeur d'une première impédance et une valeur d'une deuxième impédance, la première impédance étant l'impédance entre la borne de sortie du dispositif d'alimentation électrique et la borne d'entrée de la carte mère, la deuxième impédance étant l'impédance entre la borne de sortie de la carte mère et la borne d'entrée de la pile, et la valeur de l'impédance cible étant moins qu'une valeur de l'impédance totale entre la borne de sortie du dispositif d'alimentation électrique et la borne d'entrée de la pile ;
   la transmission (S220) d'informations d'instruction au dispositif d'alimentation électrique par le dispositif électronique, ces informations d'instruction demandant au dispositif d'alimentation électrique de régler un courant de sortie du dispositif d'alimentation électrique selon la valeur de l'impédance cible.

2. Procédé selon la revendication 1, **caractérisé en ce que** la valeur de l'impédance cible est R = (V0-(V1+∆V))/I, V0 représentant une tension d'entrée du dispositif d'alimentation électrique, V1 représentant une tension de la borne d'entrée de la pile, ∆V représentant une différence de tension entre la borne d'entrée et la borne de sortie de la carte mère, et I représentant un courant d'entrée reçu par le dispositif électronique venant du dispositif d'alimentation électrique.

3. Procédé selon la revendication 1, **caractérisé en ce que** la valeur de l'impédance cible est R = (V0-(V1+I*R"))/I, V0 représentant une tension d'entrée du dispositif d'alimentation électrique, V1 représentant une tension de la borne d'entrée de la pile, I représentant un courant d'entrée reçu par le dispositif électronique venant du dispositif d'alimentation électrique, et R" étant une valeur fixe ou déterminée en se basant sur l'impédance entre la borne d'entrée et la borne de sortie de la carte mère.

**4.** Procédé selon la revendication 3, **caractérisé en ce que**, avant la détermination de l'impédance cible par le dispositif électronique, ce procédé comprend en outre :

la détermination (S230) de l'impédance entre la borne d'entrée et la borne de sortie de la carte mère ;
la détermination de l'impédance cible comprenant :

la détermination de l'impédance cible comme R = (V0-(V1+I*R"))/I en réponse à l'impédance entre la borne d'entrée et la borne de sortie de la carte mère étant plus grande qu'un seuil prédéterminé ;
la détermination de l'impédance cible comme R = (V0-V1)/I en réponse à l'impédance entre la borne d'entrée et la borne de sortie de la carte mère étant plus petite que ou égale au seuil prédéterminé.

**5.** Dispositif électronique (500) comprenant :

une carte mère (510), dans laquelle une borne d'entrée de la carte mère est connectée à une borne de sortie d'une interface de charge, une borne d'entrée de l'interface de charge est connectée à une borne de sortie d'un dispositif d'alimentation électrique, et une borne de sortie de la carte mère est connectée à une borne d'entrée d'une pile ;
un contrôleur (520), **caractérisé en ce que** ce contrôleur est configuré de façon à exécuter des opérations comprenant :

dans un processus de charge de la pile, la détermination d'une impédance cible par le dispositif électronique, une valeur de cette impédance cible étant calculée par une valeur d'une première impédance et une valeur d'une deuxième impédance, la première impédance étant l'impédance entre la borne de sortie du dispositif d'alimentation électrique et la borne d'entrée de la carte mère, la deuxième impédance étant l'impédance entre la borne de sortie de la carte mère et la borne d'entrée de la pile, et la valeur de l'impédance cible étant moins qu'une valeur de l'impédance totale entre la borne de sortie du dispositif d'alimentation électrique et la borne d'entrée de la pile ;
la transmission d'informations d'instruction au dispositif d'alimentation électrique par le dispositif électronique, ces informations d'instruction demandant au dispositif d'alimentation électrique de régler un courant de sortie du dispositif d'alimentation électrique selon la valeur de l'impédance cible.

**6.** Dispositif électronique selon la revendication 5, **caractérisé en ce que** l'impédance cible est R = (V0-(V1+ΔV))/I, V0 représentant une tension d'entrée du dispositif d'alimentation électrique, V1 représentant une tension de la borne d'entrée de la pile, ΔV représentant une différence de tension entre la borne d'entrée et la borne de sortie de la carte mère, et I représentant un courant d'entrée reçu par le dispositif électronique venant du dispositif d'alimentation électrique.

**7.** Dispositif électronique selon la revendication 5, **caractérisé en ce que** l'impédance cible est R = (V0-(V1+I*R"))/I, V0 représentant une tension d'entrée du dispositif d'alimentation électrique, V1 représentant une tension de la borne d'entrée de la pile, I représentant un courant d'entrée reçu par le dispositif électronique venant du dispositif d'alimentation électrique, et R" étant une valeur fixe ou déterminée en se basant sur l'impédance entre la borne d'entrée et la borne de sortie de la carte mère.

**8.** Dispositif électronique selon la revendication 7, **caractérisé en ce que**, avant la détermination de l'impédance cible, le contrôleur est configuré en outre de façon à :

déterminer l'impédance entre la borne d'entrée et la borne de sortie de la carte mère ;
le contrôleur étant configuré spécifiquement de façon à :

déterminer l'impédance cible comme R = (V0-(V1+I*R"))/I en réponse à l'impédance entre la borne d'entrée et la borne de sortie de la carte mère étant plus grande qu'un seuil prédéterminé ;
déterminer l'impédance cible comme R = (V0-V1)/I en réponse à l'impédance entre la borne d'entrée et la borne de sortie de la carte mère étant plus petite que ou égale au seuil prédéterminé.

FIG. 1

200

During charging the battery, the electronic device determines target impedance, the target impedance of the calculating charging loop includes first impedance and second impedence, the first impedance is impedance between an output terminal of the power supply device and an input terminal of the mainboard, the second impedance is impedance between an output of the mainboard and an input terminal of a battery, and the target impedance is less than total impedance between the output terminal of the power supply device and the input terminal of the battery — S210

The electronic device sends indicative information to the power supply device,the indicative information indicates an output current of the power supply device that is adjusted by the power supply device according to the target impedance — S220

FIG. 2

FIG. 3

200

Determining impedance between an input terminal and an output terminal of the mainboard — S230

During charging the battery, the electronic device determines target impedance, the target impedance of the calculating charging loop includes first impedance and second impedence, the first impedance is impedance between an output terminal of the power supply device and an input terminal of the mainboard, the second impedance is impedance between an output of the mainboard and an input terminal of a battery, and the target impedance is less than total impedance between the output terminal of the power supply device and the input terminal of the battery — S210

The electronic device sends indicative information to the power supply device,the indicative information indicates an output current of the power supply device that is adjusted by the power supply device according to the target impedance — S220

FIG. 4

Electronic device 500

Mainboard
510

Controller
520

FIG. 5

600

During charging the battery, the electronic device determines a voltage V1 of an input terminal of the battery and a voltage difference ΔV between an input terminal and an output terminal of a mainboard of the charging path ⟶ S610

Determining a feedback voltage V according to the voltage V1 of the input terminal of the battery and the voltage difference ΔV between the input terminal and the output terminal of the mainboard of the charging path, wherein the feedback voltage satisfys: V1<V≤(V1+ΔV) ⟶ S620

Transmitting, by the electronic device, the feedback voltage to the power supply device, such that the power supply device adjusts output current of a charging power supply device of the charging path according to the feedback voltage ⟶ S630

## FIG. 6

600

During charging the battery, the electronic device determines a voltage V1 of an input terminal of the battery and a voltage difference ΔV between an input terminal and an output terminal of a mainboard of the charging path ⟶ S610

Determining impedance between an input terminal and an output terminal of the mainboard ⟶ S640

Determining a feedback voltage V according to the voltage V1 of the input terminal of the battery and the voltage difference ΔV between the input terminal and the output terminal of the mainboard of the charging path, wherein the feedback voltage satisfys: V1<V≤(V1+ΔV) ⟶ S620

Transmitting, by the electronic device, the feedback voltage to the power supply device, such that the power supply device adjusts output current of a charging power supply device of the charging path according to the feedback voltage ⟶ S630

## FIG. 7

Electronic device 800

| Mainboard 810 |
| Controller 820 |

**FIG. 8**

900

Receiving target impedance determined by an electronic device, the target impedance includes first impedance and second impedence, the first impedance is impedance between an output terminal of the power supply device and an input terminal of the mainboard, the second impedance is impedance between an output of the mainboard and an input terminal of a battery, and the target impedance is less than total impedance between the output terminal of the power supply device and the input terminal of the battery
S910

Adjusting output current of the power supply device according to the target impedance
S920

**FIG. 9**

Power supply device 1000

| Output circuit 1010 |
| Controller 1020 |

**FIG. 10**

1100

Receiving the feedback volrage V determined by the electronic device, the feedback voltage V satisfys: V1<V≤(V1+ΔV), wherein V1 represents a voltage of an input terminal of the battery, and ΔV is a voltage difference between an input terminal and an output terminal of the mainboard ⌐⌐ S1110

Adjusting output current of the power supply device according to the feedback voltage ⌐⌐ S1120

## FIG. 11

Power supply device 1200

Output circuit 1210

Controller 1220

## FIG. 12

~10                    20

Power supply device

21

Communication control circuit

Battery  ⌐ 30

23

## FIG. 13

FIG. 14

**EP 3 968 487 B1**

**REFERENCES CITED IN THE DESCRIPTION**

**Patent documents cited in the description**

- EP 3101761 A1
- CN 104113114 A